Europäisches Patentamt

European Patent Office

Office européen des brevets

(11) Veröffentlichungsnummer: **0 496 112 A2**

# EUROPÄISCHE PATENTANMELDUNG

(21) Anmeldenummer: **91122250.3**

(22) Anmeldetag: **27.12.91**

(51) Int. Cl.5: **C08K 3/24**, C08J 5/18,
H01G 4/32, H05K 9/00

(30) Priorität: **23.01.91 DE 4101869**

(43) Veröffentlichungstag der Anmeldung:
**29.07.92 Patentblatt 92/31**

(84) Benannte Vertragsstaaten:
**CH DE FR GB LI NL**

(71) Anmelder: **BASF Aktiengesellschaft
Carl-Bosch-Strasse 38
W-6700 Ludwigshafen(DE)**

(72) Erfinder: **Fisch, Herbert, Dr.
In der Eselsweide 8
W-6706 Wachenheim(DE)**

(54) Kunststoffmischung mit ferromagnetischen oder ferroelektrischen Füllstoffen.

(57) Die Erfindung betrifft eine Kunststoffmischung aus einem niedrig schmelzenden thermoplastischen Polymeren und 1 bis 90 % eines ferroelektrischen oder ferromagnetischen Ferrits, Titanats oder Zirkonats mit einem Durchmesser von 5 bis 200 nm.

EP 0 496 112 A2

Die Erfindung betrifft Kunststoffmischungen aus einem niedrig schmelzenden thermoplastischen Polymeren und ferromagnetischen oder ferroelektrischen Füllstoffen.

In der EP-A 240 809 sind Kunststoffmischungen aus einem temperaturbeständigen thermoplastischen Polymeren und einem ferro- oder piezoelektrischen Ferrit, Titanat oder Zirkonat einer Korngröße von 100 bis 5000 Å beschrieben. Die Mischungen werden hergestellt, indem man die Metallkomponenten in Form von metallorganischen Verbindungen zusammengibt, mit den Thermoplasten mischt, die zur Hydrolyse benötigte Menge Wasser zufügt und die Mischung auf Temperaturen oberhalb von 250 °C erwärmt. Dabei kommen wegen der hohen Temperaturbelastung in der Kristallisationsstufe nur solche Polymere in Betracht, die eine entsprechende Temperaturbeständigkeit aufweisen.

Der Erfindung lag nun die Aufgabe zugrunde, Kunststoffmischungen aus niedrigschmelzenden thermoplastischen Kunststoffen und ferromagnetischen bzw. ferroelektrischen Füllstoffen bereitzustellen, die sich zu Bauteilen oder Folien für die Elektrotechnik verarbeiten lassen.

Gegenstand der Erfindung ist eine Kunststoffmischung, enthaltend

A) 99 bis 10 Gew.-% eines thermoplastischen Polymeren, ausgewählt aus

einem Homo- oder Copolymeren des Ethylens, Polypropylen, Polyisobutylen, einem Homo- oder Copolymeren des Styrols, Polyethylenterephthalat, Polybutylenterephthalat, Polyoxymethylen und einem thermoplastischen Polyurethan,

B) 1 bis 90 Gew.-% eines Ferrits, Titanats oder Zirkonats, welches eine sphärische oder nadelförmige Morphologie aufweist und einen Durchmesser von 5 bis 200 nm aufweist.

Geeignete thermoplastische Polymere sind Polyolefine, z.B. Polyethylen, Copolymere des Ethylens mit Vinylacetat, Acrylsäure, Propylen, sowie Polyethylenionomere, Polypropylen und Polyisobutylen; Styrolpolymerisate, wie Polystyrol und Copolymere des Styrols mit Acrylnitril, sowie die entsprechenden kautschukmodifizierten Polymeren; Polyester, wie z.B. Polyethylenterephthalat und Polybutylenterephthalat; ferner Polyoxymethylen und thermoplastische Polyurethane.

Als keramische Füllstoffe mit ferroelektrischen oder ferromagnetischen Eigenschaften geeignet sind Ferrite der allgemeinen Formel $MeO \cdot Fe_2O_3$ - (mit Me = Mn, Zn, Cu, Cd, Mg, Sr, Ni, Co, Ba) sowie $Fe_2O_3$, $CrO_2$, $Fe_3O_4$, Titanate der Formel $MeTiO_3$, wie z.B. $BaTiO_3$, $Ba_xTi_{(1-x)}O_3$ $Ba_xTi_{(1-x)}O_3$, Bleizirkontitanate (PZT) und Bleilanthanzirkontitanate (PLZT). Die Füllstoffe können sphärische oder nadelförmige Morphologie aufweisen. Sphärische Teilchen haben bevorzugt einen Durchmesser von 10 bis 100 nm, nadelförmige Teilchen haben einen Durchmesser von vorzugsweise 30 bis 90 nm, ihre Länge kann bis zu 1000 nm betragen.

Die Charakterisierung der Füllstoffmorphologie erfolgt über Lichtstreumethoden in Dispersion oder durch elektronenmikroskopische Aufnahmen. Die Stoffzusammensetzung wird über gängige elementaranalytische Untersuchung und Aufnahme von Röntgenbeugungsspektren bestimmt. Die Halbwertsbreite der Röntgenreflexe lassen ebenfalls Aussagen über die Teilchengröße zu.

Die Einarbeitung der Füllstoffe in den Thermoplasten ist unter schonenden Bedingungen durchzuführen, damit der Thermoplast nicht zersetzt wird.

Folgende geeignete Einarbeitungsmethoden sind zu nennen:

1. Direktes Einkonfektionieren der Füllstoffe in eine Polymerschmelze über eine Mischschnekke.

2. Herstellung einer Dispersion des Füllstoffes in einem Lösungsmittel (gegebenenfalls unter Zusatz eines geeigneten Dispergators). Anschließend Dosierung dieser hochgefüllten Dispersion zu einer Polymerschmelze. Wasser bzw. Lösungsmittel werden dann in einem Entgasungsschuß nach Homogenisierung abdestilliert.

3. Synthese des Füllstoffes in der Polymerschmelze: Dazu ist die Durchführung der Synthese im Reaktionsextruder notwendig. Hier ist neben der Homogenisierung und Durchmischung der Reaktanden, Temperaturvariation und Scherbeanspruchung möglich. Verwendete Lösungsmittel bzw. niedermolekulare Reaktionsprodukte können in der Entgasungszone des Extruders abgetrennt werden.

Die erfindungsgemäßen Kunststoffmischungen können nach üblichen Methoden zu Bauteilen spritzgegossen oder zu Folien extrudiert werden.

Die Granulate lassen sich mit entsprechenden Spritzgußformen zu komplizierten Geometrien verspritzen.

Anwendungen liegen bei den ferrithaltigen Polymeren im Bereich von aktiven und passiven Mikrowellenbauteilen. In Frage kommen Anwendungen in Form von Ferrit- und Übertragerkernen. Der Einsatz in Mikrowellenfiltern oder auch Entstörbauteilen ist ebenfalls möglich.

$BaTiO_3$-, PZT- und PLZT-haltige Granulate lassen sich zu dielektrischen oder piezoelektrischen Folien weiterverarbeiten. Diese Folien können in Wickelkondensatoren eingesetzt werden. Einsatzgebiete für PZT- oder PLZT-Folien sind z.B. akustische Schallwellenaufnehmer.

Die Ferrit- bzw. Eisenoxid- und $CrO_2$-haltige Composites können auch als Abschirmmaterialien im Mikrowellenbereich eingesetzt werden.

Beispiele

Beispiel 1

Kombination Polyethylen/BaTiO₃/Verfahren 1

Mittels eines Sol-Gel-Verfahrens wird eine agglomeratfreie Dispersion von $BaTiO_3$ in Diethylenglykoldiethylether (Korngröße $BaTiO_3$: 20-40 nm) hergestellt. Der Volumenanteil an $BaTiO_3$ beträgt 25 %. Diese Suspension wird mit einem Volumenstrom von 8 l/h in einer zweiten Zone eines Doppelwellenextruders mit einer in der ersten Stufe erzeugten Polyethylenschmelze mit einem Massenstrom von 5 kg/h bei 215°C durchmischt. Das eingesetzte LD-Polyethylen ist durch einen MFI (190/2,16) von 0,8 charakterisiert. Anschließend an die Mischzone werden in der Entgasungszone 6 l/h Diethylenglykoldiethylether bei 30 mbar abdestilliert. Man erhält ein Granulat mit einem Füllstoffgehalt von 40 Vol-% an $BaTiO_3$.

Beispiel 2

Kombination Polypropylen/Mn-Zn-Ferrit/Verfahren 1

In N-Methylpyrrolidon wird ein superparamagnetischer Mn-Zn-Ferrit mit einem Anteil von 20 Vol-% dispergiert. Nach dem im ersten Beispiel beschriebenen Verfahren wird diese Dispersion mit einem Volumenstrom von 15 l/h zu einer Polypropylenschmelze (Massenstrom 5 kg/h) zugepumpt und bei 285°C vermischt (MFI-Wert (230/2,16) des eingesetzten Polypropylens: 15). Im Entgasungsteil des Extruders werden 12 l/h N-Methylpyrrolidon bei einem Vakuum von 40 mbar abdestilliert. Das extrudierte Granulat weist einen Ferrit-Gehalt von 37,5 Vol-% auf.

Beispiel 3

Kombination Polystyrol/BaTiO₃/Verfahren 1

Eine agglomeratfreie Dispersion von $BaTiO_3$ in Diethylenglykoldiethylether (Volumengehalt: 25 %) wird entsprechend Beispiel 1 in einem Doppelwellenentgasungsextruder mit einem Volumenstrom von 16 l/h zu einer in der Aufschmelzzone erzeugten Polystyrolschmelze (MFI 200/5) mit einem Massenstrom von 5 kg/h bei 230°C vermischt. Nach dem Durchlauf der Mischstrecke werden 12 l/h Diethylenglykoldiethylether im Vakuumteil abdestilliert, das erhaltene Granulat weist einen Volumengehalt von 42,3 % $BaTiO_3$ auf.

Beispiel 4

Kombination Polypropylen/BaTiO₃/Verfahren 2

Getrocknetes desagglomeriertes nanokristallines $BaTiO_3$ (Partikelgröße 20-50 nm) wird mit einem Massenstrom von 5 kg/h über einen Feststoffseitenextruder zu einer Polypropylenschmelze (Massestrom 5 kg/h) zudosiert. Das nach Homogenisierung und Extrusion erhaltene Granulat weist einen Feststoffgehalt von 48,3 Gew.-% auf.

Beispiel 5

Kautschukmodifiziertes          Polystyrol/Mn-Zn-Ferrit/Verfahren 2

Zu einer Schmelze von kautschukmodifiziertem Polystyrol (MVI 200/5: 3; (Massenstrom 5 kg/h) werden über einen Seitenextruder 8 kg/h eines superparamagnetischen Mn-Zn-Ferrites bei 240°C zudosiert. Die Mischung wird homogenisiert und extrudiert. Man erhält ein gefülltes Granulat mit einem Feststoffgehalt von 59,8 Gew.-%.

Beispiel 6

Polyethylen/BaTiO₃/Verfahren 3

Zu einer Polyethylenschmelze (Massenstrom 5 kg/h) wird in der ersten Zone eines Doppelwellenextruders bei 218°C über einen Seitenextruder Ba(OH)₂•8H₂O (Massenstrom 4,04 kg/h) zudosiert. In der folgenden Zone wird über eine Kolbenhubpumpe Ti(OBu)₄ (Massenstrom 4,38 kg/h) zu dieser Mischung zudosiert. In den beiden folgenden Zonen findet die Umsetzung zu nanokristallinem $BaTiO_3$ statt. In der anschließenden Entgasungszone werden entstandenes n-Butanol und überschüssiges Wasser bei 40 mbar im Vakuum entgast. Man extrudiert ein gefülltes Granulat mit einem Gehalt von 37,5 Gew.-% an $BaTiO_3$. Die $BaTiO_3$-Partikelgröße liegt unter 20 nm.

**Patentansprüche**

1.   Kunststoffmischung, enthaltend
    A) 99 bis 10 Gew.-% eines thermoplastischen Polymeren, ausgewählt aus

    einem Homo- oder Copolymeren des Ethylens, Polypropylen, Polyisobutylen, einem Homo- oder Copolymeren des Styrols, Polyethylenterephthalat, Polybutylenterephthalat, Polyoxymethylen und einem thermoplastischen Polyurethan, und
    B) 1 bis 90 Gew.-% eines Ferrits, Titanats oder Zirkonats, welches eine sphärische oder nadelförmige Morphologie und einen Durchmesser von 5 bis 200 nm aufweist.

2.   Mikrowellenbauteile aus der Kunststoffmischung nach Anspruch 1.

3.  Folien für Wickelkondensatoren aus der Kunststoffmischung nach Anspruch 1.

4.  Abschirmmaterialien für Mikrowellen aus der Kunststoffmischung nach Anspruch 1.